# EUROPEAN PATENT APPLICATION

(11) **EP 4 708 367 A1**
(43) Date of publication of application: **11.03.2026**
(21) Application number: 24815410.6
(22) Date of filing: 24.05.2024
(51) Int. Cl.: H01L 31/048

(54) **SOLAR CELL MODULE**

(30) Priority: 30.05.2023 JP 2023088752; 07.09.2023 JP 2023145335; 28.12.2023 JP 2023223123
(71) Applicant: Toppan Holdings Inc., Tokyo 110-0016 (JP)
(72) Inventor: OGASAWARA, Motoyuki, Tokyo 110-0016 (JP); MAEDA, Kanami, Tokyo 110-0016 (JP); FUNAKI, Hayato, Tokyo 110-0016 (JP)
(74) Representative: Hasegawa, Kan
(86) International application number: PCT/JP2024/019234
(87) International publication number: WO 2024/247927

(57) **Abstract**

A pattern printed layer includes a first color pattern layer provided on one surface of a light transmissive base material and composed of a plurality of first color dots, and a second color pattern layer provided on the first color pattern layer and composed of a plurality of second color dots. In a printed material, each of the plurality of first color dots includes a first color binder and a plurality of first color pigment chips dispersed within the first color binder, each of the plurality of second color dots includes a second color binder and a plurality of second color pigment chips dispersed within the second color binder, any one of the plurality of first color pigment chips and the plurality of second color pigment chips is first interference pigments of multiple colors that each generate a different first interference light, the other of the plurality of first color pigment chips and the plurality of second color pigment chips is second interference pigments generating a single-colored second interference light different from a color mixture shown by the plurality of first interference pigments, and the plurality of first interference lights and the second interference light are additively mixed.

## Description

### Technical Field

The present disclosure relates to a solar cell module.

### Background Art

To achieve carbon neutrality and a decarbonized society by 2050, there is a growing demand for the widespread adoption of net-zero energy buildings (ZEBs), which can significantly reduce energy consumption in buildings. A ZEB refers to a building that aims to achieve a zero balance of annual primary energy consumption in a building while realizing a comfortable indoor environment. Since people are active in buildings, it is impossible to completely eliminate energy consumption. However, by reducing energy use through energy saving and generating energy through energy creation to compensate for the energy used, it is possible to achieve a net zero energy consumption.

Examples of energy creation methods in which fossil fuels are not used include solar power generation, wind power generation, and biomass power generation. Considering installation space and costs, solar power generation is suitable as an energy creation method for buildings.

The rooftop area of a building is often occupied by outdoor units for air conditioning and the like, making it necessary to install solar cell modules on the walls in addition to the rooftop to achieve sufficient power generation.

### Citation List

### Patent Literature

Patent Literature 1: Japanese Unexamined Patent Publication No. 2021-027266
Patent Literature 2: Japanese Patent No. 5725581
Patent Literature 3: Japanese Patent No. 6839319

### Summary of Invention

### Technical Problem

When installing a solar cell module on a wall, conventional solar cell modules lack sufficient design aesthetics, and improvement is desired.

An object of the present disclosure is to provide a solar cell module with improved design aesthetics.

### Solution to Problem

One aspect of the present disclosure relates to a solar cell module including: a solar cell; and a printed material disposed on a light-receiving surface side of the solar cell and including a light transmissive base material and a pattern printed layer. In this solar cell module, the pattern printed layer includes a first color pattern layer provided on one surface of the light transmissive base material and composed of a plurality of first color dots, and a second color pattern layer provided on the first color pattern layer and composed of a plurality of second color dots. In this printed material, each of the plurality of first color dots includes a first color binder and a plurality of first color pigment chips dispersed within the first color binder, each of the plurality of second color dots includes a second color binder and a plurality of second color pigment chips dispersed within the second color binder, any one of the plurality of first color pigment chips and the plurality of second color pigment chips is first interference pigments of multiple colors that each generate a different first interference light, the other of the plurality of first color pigment chips and the plurality of second color pigment chips is second interference pigments generating a single-colored second interference light different from a color mixture shown by the plurality of first interference pigments, and the plurality of first interference lights and the second interference light are additively mixed.

A solar cell module according to one aspect of the present disclosure includes: as one aspect, a solar cell; and a vapor deposition layer disposed on a light-receiving surface side of the solar cell and formed by metal vapor deposition.

One aspect of the present disclosure relates to a solar cell module including: at least one solar cell; and a printed material disposed on a light-receiving surface side of the solar cell and having a pattern printed layer. The pattern printed layer includes a first color pattern layer composed of a plurality of first color dots, and a second color pattern layer provided so as to overlap with the first color pattern layer and composed of a plurality of second color dots. Each of the plurality of first color dots includes a first color binder and a plurality of first color pigment chips dispersed within the first color binder, and each of the plurality of second color dots includes a second color binder and a plurality of second color pigment chips dispersed within the second color binder. Any one of the plurality of first color pigment chips and the plurality of second color pigment chips is first interference pigments of multiple colors that generate first interference lights different from each other, and the other of the plurality of first color pigment chips and the plurality of second color pigment chips is second interference pigments generating a single-colored second interference light different from a color mixture shown by the first interference pigments of multiple colors. At least one of the first interference pigments and the second interference pigments includes a small particle size grade interference pigment including a particle size range of 5 µm to 25 µm and a large particle size grade interference pigment including a particle size range of 25 µm to 40 µm. In the pattern printed layer of this solar cell module, the small particle size grade interference pigment is disposed to fill gaps between the large particle size grade interference pigments, and the plurality of first interference lights and the second interference light are additively mixed.

### Advantageous Effects of Invention

According to the present disclosure, it is possible to provide a solar cell module with improved design aesthetics.

### Brief Description of Drawings

[FIG. 1] FIG. 1 is a cross-sectional view schematically showing a solar cell module according to Embodiment 1-1.
[FIG. 2] FIG. 2 is a cross-sectional view schematically showing a printed material included in the solar cell module shown in FIG. 1.
[FIG. 3] FIG. 3 is a cross-sectional view schematically showing a pattern printed layer included in the printed material shown in FIG. 2.
[FIG. 4] FIG. 4 is a cross-sectional view schematically showing a printed material of a solar cell module according to Embodiment 1-2.
[FIG. 5] FIG. 5 is a cross-sectional view schematically showing a white pattern layer included in the printed material shown in FIG. 4.
[FIG. 6] FIG. 6 is a cross-sectional view schematically showing a printed material of a solar cell module according to Embodiment 1-3.
[FIG. 7] FIG. 7 is a cross-sectional view schematically showing a printed material of a solar cell module according to Embodiment 1-4.
[FIG. 8] FIG. 8 is a cross-sectional view schematically showing a solar cell module according to Embodiment 2-1.
[FIG. 9] FIG. 9 is a cross-sectional view schematically showing a solar cell module according to Embodiment 2-2.
[FIG. 10] FIG. 10 is a cross-sectional view schematically showing a solar cell module according to Embodiment 2-3.
[FIG. 11] FIG. 11 is a cross-sectional view schematically showing a solar cell module according to Embodiment 2-4.
[FIG. 12] FIG. 12 is a cross-sectional view schematically showing a solar cell module according to Embodiment 2-5.
[FIG. 13] FIG. 13 is a cross-sectional view schematically showing a solar cell module according to one embodiment of a third disclosure.
[FIG. 14] FIG. 14 is a cross-sectional view schematically showing a pattern printed layer of a printed material.

### Description of Embodiments

### [First disclosure]

The printed material described in Japanese Patent No. 5725581 includes a first color pattern layer, a second color pattern layer, and a third color pattern layer, and pigment chips included in each pattern layer are any one of a red interference pigment, a green interference pigment, and a blue interference pigment. In this printed material, the number of pattern layers is large in order to make the color development more vivid than conventional printing. The decorative sheet described in Japanese Patent No. 6839319 includes a first pattern layer containing a plurality of types of interference pigments and exhibiting a first color mixture, and a second pattern layer containing a plurality of types of interference pigments and exhibiting a second color mixture different from the first color mixture. In this decorative sheet, since each of the first pattern layer and the second pattern layer contains a plurality of types of interference pigments, there is a concern that color matching and registration work during printing will become complicated. Therefore, when the printed materials of Japanese Patent No. 5725581 and Japanese Patent No. 6839319 are combined with a solar cell module, these problems may occur. In addition, since the solar cell module generates power by receiving sunlight, if sunlight is excessively blocked by the printed materials, there is a problem that power generation efficiency may decrease.

The present disclosure is to solve the above-described problems, and an object thereof is to provide a solar cell module that includes a printed material capable of expressing a three-dimensional pattern even with a small number of printed layers, and simplifying color matching and registration work during printing, while suppressing a decrease in power generation efficiency.
[1] The present disclosure relates to, as one aspect, a solar cell module including: a solar cell; and a printed material disposed on a light-receiving surface side of the solar cell and including a light transmissive base material and a pattern printed layer. In this solar cell module, the pattern printed layer includes a first color pattern layer provided on one surface of the light transmissive base material and composed of a plurality of first color dots, and a second color pattern layer provided on the first color pattern layer and composed of a plurality of second color dots. In this printed material, each of the plurality of first color dots includes a first color binder and a plurality of first color pigment chips dispersed within the first color binder, each of the plurality of second color dots includes a second color binder and a plurality of second color pigment chips dispersed within the second color binder, any one of the plurality of first color pigment chips and the plurality of second color pigment chips is first interference pigments of multiple colors that each generate a different first interference light, the other of the plurality of first color pigment chips and the plurality of second color pigment chips is second interference pigments generating a single-colored second interference light different from a color mixture shown by the plurality of first interference pigments, and the plurality of first interference lights and the second interference light are additively mixed.

In this solar cell module, since any one pattern layer of the first color pattern layer and the second color pattern layer includes interference pigments of multiple colors that generate interference lights different from each other, a three-dimensional pattern expression can be realized even with a small number of printed layers. Furthermore, in this printed material, the pattern layer including the interference pigments that generate a plurality of interference lights may be any one layer of the first color pattern layer and the second color pattern layer, so that color matching and registration work during printing can be simplified. Therefore, according to this printed material, a three-dimensional pattern can be expressed even with a small number of printed layers, and color matching and registration work during printing can be simplified. In addition, the printed material can suppress a decrease in power generation efficiency of the solar cell module by ensuring transmissivity to sunlight for the solar cell while obtaining these effects.
[2] The solar cell module of [1] above may further include: a white pattern layer provided on the second color pattern layer and composed of a plurality of silver dots, in which each of the plurality of silver dots includes a silver binder and a plurality of silver pigment chips dispersed within the silver binder. In this case, the color development of the first color pattern layer and the second color pattern layer is excellent, and the pattern printed layer can have a pattern that gives a whitish impression.
[3] The solar cell module of [1] or [2] above may further include a transmissive smoke-printed layer provided on an outermost surface opposite to the light transmissive base material side with respect to the pattern printed layer. In this case, the color development of the first color pattern layer and the second color pattern layer is superior. Furthermore, since the transmissive smoke-printed layer has transmissivity, a decrease in power generation efficiency of the solar cell module is favorably suppressed.
[4] In the solar cell module of any one of [1] to [3] above, the first interference pigments and the second interference pigments each may include titanium dioxide-coated mica having a particle size of 25 µm to 60 µm. When including titanium dioxide-coated mica having a particle size of 25 µm or more, the transmissivity and color development of the pattern printed layer can be made good. When including titanium dioxide-coated mica having a particle size of 60 µm or less, a decrease in resolution and gradation of the pattern printed layer can be suppressed.
[5] In the solar cell module of any one of [1] to [4] above, a content of the plurality of first color pigment chips may be in a range of 0.5 parts by weight to 20 parts by weight relative to 100 parts by weight of the first color binder, and a content of the plurality of second color pigment chips may be in a range of 0.5 parts by weight to 20 parts by weight relative to 100 parts by weight of the second color binder. When the content of the plurality of first color pigment chips is in a range of 0.5 parts by weight or more, the pattern of the first color pattern layer is well expressed. When the content of the plurality of first color pigment chips is in a range of 20 parts by weight or less, a decrease in film-forming property and transmissivity of the first color pattern layer can be suppressed. Similarly, when the content of the plurality of second color pigment chips is in a range of 0.5 parts by weight to 20 parts by weight relative to 100 parts by weight of the second color binder, a decrease in film-forming property and transmissivity of the second color pattern layer can be suppressed while the pattern of the second color pattern layer is well expressed.

According to the present disclosure, it is possible to provide a solar cell module that includes a printed material capable of expressing a three-dimensional pattern even with a small number of printed layers, and simplifying color matching and registration work during printing, while suppressing a decrease in power generation efficiency.

Specific examples of the solar cell module according to embodiments of the present disclosure will be described below with reference to the drawings. The present disclosure is not limited to these examples, and is indicated by the claims, and it is intended that all modifications within the meaning and scope equivalent to the claims are included. In the following description, the same elements are denoted by the same reference numerals in the description of the drawings, and redundant descriptions are omitted.

### [Embodiment 1-1]

Generally, since the surface of a solar cell embedded in a solar cell module only exhibits a black or dark blue color, attempts have been made to variously color the exterior of the solar cell module for the purpose of improving its design aesthetics. In the present embodiment, a printed material is applied to the surface of the solar cell module in a manner capable of improving the design aesthetics of the solar cell module's exterior while significantly suppressing a decrease in the power generation amount of the solar cell.

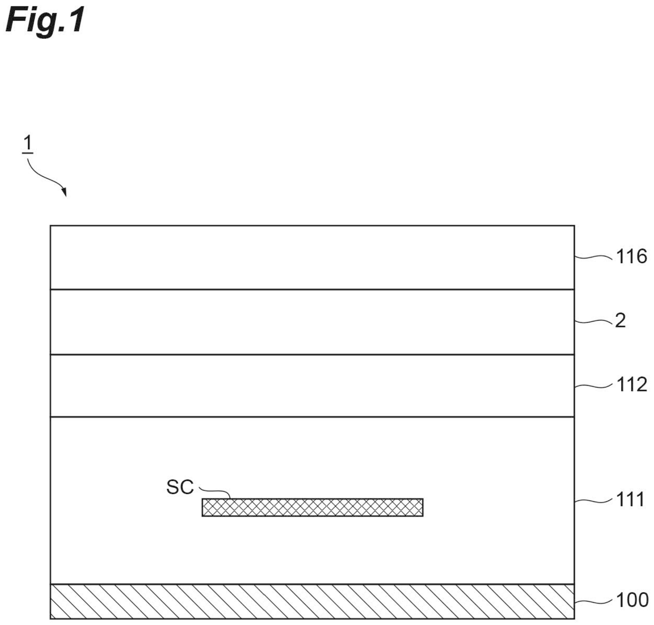

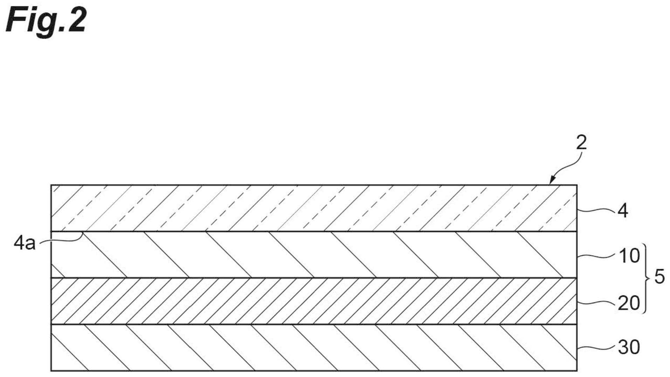

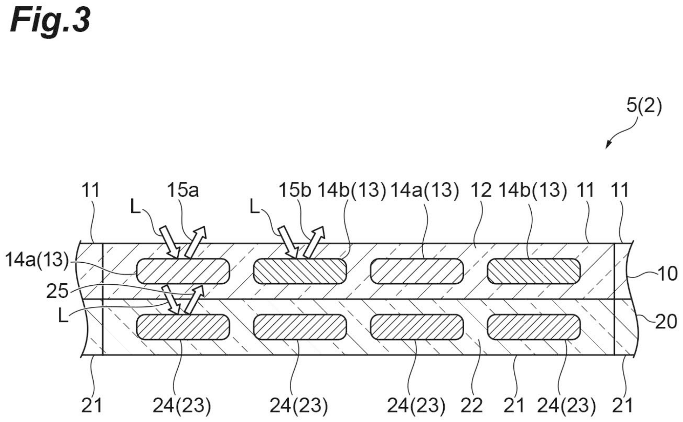

FIG. 1 is a cross-sectional view schematically showing a solar cell module according to Embodiment 1-1. FIG. 2 is a cross-sectional view schematically showing a printed material included in the solar cell module shown in FIG. 1. FIG. 3 is a cross-sectional view schematically showing a pattern printed layer included in the printed material shown in FIG. 2.

As shown in FIG. 1, a thin plate-shaped solar cell SC is placed on a back surface material 100 in a state embedded in a sealing material layer 111 with its light-receiving surface facing upward. A surface plate 112 is laminated and adhered on the light-receiving surface side of the solar cell SC for the purpose of protecting the solar cell SC. A printed material 2 is laminated on the surface plate 112 for the purpose of coloring a solar cell module 1. A hard coat layer (also referred to as a clear layer) 116 is laminated on the printed material 2.

The solar cell SC may be a photoelectric conversion element formed in a thin plate shape with a thickness of about 0.2 mm, such as crystalline or amorphous silicon, thin-film silicon, perovskite-based materials, chalcopyrite-based materials, group III-V based materials, CdTe, or CIS, and may generate power by absorbing light having a wavelength mainly in the visible light region. The sealing material layer 111 may be made of a transparent material such as ethylene vinyl acetate (EVA), polyvinyl butyral (PVB), polyolefin resin, ionomer resin, or silicone resin, and may be formed to surround the solar cell SC, as shown in the drawing, in a layered shape with a thickness of about 1 mm.

The back surface material 100 may be formed of polyethylene terephthalate (PET), a polycarbonate resin, an acrylic resin, glass, or a metal (such as aluminum) in a layered, film-like, or plate-like shape. The surface plate 112 may be a plate-like member formed of a transparent material such as a polycarbonate resin, an acrylic resin, or glass with a thickness of about 3 mm. Adhesion between the surface plate 112 and the sealing material layer 111 and between the back surface material 100 and the sealing material layer 111 may be achieved by the adhesive force of the sealing material layer 111.

The hard coat layer 116 may be laminated for the purpose of protecting a decorative layer, and may be similar to those applied to painted surfaces of vehicles or the like, for example. The thickness of the hard coat layer 116 may be 5 to 50 µm, preferably 10 to 40 µm, and more preferably 15 to 30 µm. As a material of the hard coat layer 116, an active energy ray-curable coating composition hardened by ultraviolet irradiation, an electron beam, or the like, or a thermosetting coating composition and the like may be used.

As shown in FIG. 2, the printed material 2 is a sheet for expressing a pattern and includes a light transmissive base material 4, a pattern printed layer 5, and a transmissive smoke-printed layer 30.

The light transmissive base material 4 is a substrate having visible light transmissivity. The light transmissive base material 4 is made of a transparent resin, for example. Examples of the transparent resin include PET, PMMA, polyethylene, polypropylene, nylon, and fluorine. The light transmissive base material 4 may be a glass substrate. The thickness of the light transmissive base material 4 is, for example, 25 µm to 250 µm. In the case of a glass substrate, the thickness is, for example, about several mm to 10 mm. If necessary, a surface protection layer may be provided on the surface side of the light transmissive base material 4 (opposite side to the pattern printed layer 5).

The pattern printed layer 5 is a layer for expressing the pattern of the printed material 2. The pattern printed layer 5 includes a first color pattern layer 10 provided on one surface 4a of the light transmissive base material 4, and a second color pattern layer 20 provided on the first color pattern layer 10.

The first color pattern layer 10 can be provided on the surface 4a by, for example, screen printing, inkjet printing, gravure printing, or offset printing. As shown in FIG. 3, the first color pattern layer 10 is composed of a plurality of first color dots 11. Here, the term "dot" refers to a point that serves as an element constituting a printed image, and its shape is not limited to a circular shape but may be rectangular, polygonal, or any other shape. Each of the plurality of first color dots 11 includes a first color binder 12 and a plurality of first color pigment chips 13 dispersed within the first color binder 12. A content of the plurality of first color pigment chips 13 is, for example, in a range of 0.5 parts by weight to 20 parts by weight relative to 100 parts by weight of the first color binder 12.

Examples of the first color binder 12 include vinyl resin, acrylic resin, thermoplastic urethane resin, polyester resin, polycarbonate resin, and fluorine resin. The thickness of the first color pattern layer 10 is, for example, 1 µm to 10 µm. The first color pattern layer 10 may contain a curing agent. In this case, the heat resistance of the first color pattern layer 10 and the adhesion of the first color pattern layer 10 to the light transmissive base material 4 can be improved.

In Embodiment 1-1, the plurality of first color pigment chips 13 are first interference pigments 14a and 14b of multiple colors that generate interference lights different from each other. Each of the first interference pigments 14a and 14b is composed of a flake (not shown) having visible light transmissivity and a metal oxide film (not shown) coating the flake. Of the incident light from the light transmissive base material 4 side to the first color pattern layer 10, light reflected at the surface of the metal oxide film and light passing through the metal oxide film and reflected at the surface of the flake interfere with each other, generating interference light. By adjusting the film thickness and the refractive index of the metal oxide film, interference light having a desired wavelength can be generated.

In Embodiment 1-1, each of the first interference pigments 14a and 14b is titanium dioxide-coated mica. The particle size range of the titanium dioxide-coated mica includes, for example, a range of 25 µm to 60 µm. Here, the "particle size" means the longest diameter of a particle cross section. Flakes constituting the first interference pigments 14a and 14b may be other than mica, for example, silica, alumina, glass, or polysilicate. The metal oxide film constituting the first interference pigments 14a and 14b may be other than titanium dioxide, for example, zirconium oxide, zinc oxide, iron oxide, or tin oxide.

Each of first interference lights 15a and 15b different from each other is generated from each of the first interference pigments 14a and 14b by incident light E incident on the first color pattern layer 10. That is, the wavelengths of the first interference lights 15a and 15b are different from each other. Accordingly, the first interference pigments 14a and 14b exhibit a color mixture. Each of the first interference pigments 14a and 14b is, for example, a red interference pigment (red pearl pigment) and a gold interference pigment (gold pearl pigment). In this case, each of the first interference lights 15a and 15b exhibits red and gold. The blending amounts of the first interference pigments 14a and 14b may be the same or different from each other.

The second color pattern layer 20 can be provided on the first color pattern layer 10 by, for example, screen printing, inkjet printing, gravure printing, or offset printing. As shown in FIG. 3, the second color pattern layer 20 is composed of a plurality of second color dots 21. Here, the term "dot" refers to a point that serves as an element constituting a printed image, and its shape is not limited to a circular shape but may be rectangular, polygonal, or any other shape. Each of the plurality of second color dots 21 includes a second color binder 22 and a plurality of second color pigment chips 23 dispersed within the second color binder 22. A content of the plurality of second color pigment chips 23 is, for example, in a range of 0.5 parts by weight to 20 parts by weight relative to 100 parts by weight of the second color binder 22.

Examples of the second color binder 22 include vinyl resin, acrylic resin, thermoplastic urethane resin, polyester resin, polycarbonate resin, and fluorine resin. The thickness of the second color pattern layer 20 is, for example, 1 µm to 10 µm. The second color pattern layer 20 may contain a curing agent. In this case, the heat resistance of the second color pattern layer 20 and the adhesion of the second color pattern layer 20 to the first color pattern layer 10 can be improved.

In Embodiment 1-1, the plurality of second color pigment chips 23 are second interference pigments 24 generating a single-colored interference light different from the color mixture shown by the first interference pigments 14a and 14b. The second interference pigments 24 are composed of a flake (not shown) having visible light transmissivity and a metal oxide film (not shown) coating the flake. Of the incident light from the light transmissive base material 4 side to the second color pattern layer 20, light reflected at the surface of the metal oxide film and light passing through the metal oxide film and reflected at the surface of the flake interfere with each other, generating interference light. By adjusting the film thickness and the refractive index of the metal oxide film, interference light having a desired wavelength can be generated.

In Embodiment 1-1, the second interference pigments 24 are titanium dioxide-coated mica. The particle size range of the titanium dioxide-coated mica includes, for example, a range of 25 µm to 60 µm. Here, the "particle size" means the longest diameter of a particle cross section. Flakes constituting the second interference pigments 24 may be other than mica, for example, silica, alumina, glass, or polysilicate. The metal oxide film constituting the second interference pigments 24 may be other than titanium dioxide, for example, zirconium oxide, zinc oxide, iron oxide, or tin oxide.

From the second interference pigments 24, a single-colored second interference light 25 is generated when incident light E is incident on the second color pattern layer 20. Accordingly, the second interference pigments 24 exhibit a single color. The second interference pigments 24 may be interference pigments that generate a single-colored second interference light 25 different from the color mixture shown by the first interference pigments 14a and 14b, and may be, for example, green interference pigments (green pearl pigments). In this case, the second interference light 25 exhibits green.

The transmissive smoke-printed layer 30 has a function to attenuate light from the viewer-facing side passing through the printed material 2. The transmissive smoke-printed layer 30 is provided on the outermost surface opposite to the light transmissive base material 4 with respect to the pattern printed layer 5. In Embodiment 1-1, the transmissive smoke-printed layer 30 is provided on the second color pattern layer 20 as shown in FIG. 2. The transmissive smoke-printed layer 30 can be provided on the second color pattern layer 20 by, for example, screen printing, inkjet printing, gravure printing, or offset printing using ink in which a small amount of carbon black is dispersed in, for example, a vinyl-based, acrylic-based, urethane-based, or polyester-based resin binder. The thickness of the transmissive smoke-printed layer 30 is, for example, 1 µm to 10 µm.

In the printed material 2, a pattern is expressed by additively mixing the first interference lights 15a and 15b generated by the first interference pigments 14a and 14b with the second interference light 25 generated by the second interference pigments 24.

The total light transmittance of the printed material 2 is, for example, 30% to 70%. In particular, it may be 50% or more to suppress a decrease in power generation efficiency of the solar cell module 1. The total light transmittance referred to herein means a value measured using a spectrophotometer (for example, Spectrophotometer UV-3600 manufactured by Shimadzu Corporation).

In the printed material 2 according to Embodiment 1-1 described above, since the first color pattern layer 10 includes the first interference pigments 14a and 14b, and the second color pattern layer 20 includes the second interference pigments 24, a three-dimensional pattern expression can be realized even with a small number of printed layers. Furthermore, in the printed material 2, since the pattern layer including interference pigments that generate interference lights different from each other is only the first color pattern layer 10 among the first color pattern layer 10 and the second color pattern layer 20, color matching and registration work during printing can be simplified. Therefore, according to the printed material 2, a three-dimensional pattern can be expressed even with a small number of printed layers, and color matching and registration work during printing can be simplified. In addition, the printed material 2 can suppress a decrease in power generation efficiency of the solar cell module 1 by ensuring transmissivity to sunlight for the solar cell SC while obtaining these effects.

In Embodiment 1-1, the printed material 2 of the solar cell module 1 includes the transmissive smoke-printed layer 30 provided on the second color pattern layer 20. Accordingly, the color development of the first color pattern layer 10 and the second color pattern layer 20 is superior. Furthermore, since the transmissive smoke-printed layer 30 has transmissivity, a decrease in power generation efficiency of the solar cell module 1 is favorably suppressed.

In Embodiment 1-1, each of the first interference pigments 14a and 14b and the second interference pigments 24 includes titanium dioxide-coated mica with a particle size of 25 µm to 60 µm. When including titanium dioxide-coated mica having a particle size of 25 µm or more, the transmissivity and color development of the pattern printed layer 5 can be made good. When including titanium dioxide-coated mica having a particle size of 60 µm or less, a decrease in resolution and gradation of the pattern printed layer 5 can be suppressed.

In Embodiment 1-1, a content of the plurality of first color pigment chips 13 is in a range of 0.5 parts by weight to 20 parts by weight relative to 100 parts by weight of the first color binder 12, and a content of the plurality of second color pigment chips 23 is in a range of 0.5 parts by weight to 20 parts by weight relative to 100 parts by weight of the second color binder. Since the content of the plurality of first color pigment chips 13 is in a range of 0.5 parts by weight or more, the pattern of the first color pattern layer 10 is well expressed. Since the content of the plurality of first color pigment chips 13 is in a range of 20 parts by weight or less, a decrease in film-forming property and transmissivity of the first color pattern layer 10 can be suppressed. Similarly, since the content of the plurality of second color pigment chips 23 is in a range of 0.5 parts by weight to 20 parts by weight relative to 100 parts by weight of the second color binder 22, a decrease in film-forming property and transmissivity of the second color pattern layer 20 can be suppressed while the pattern of the second color pattern layer 20 is well expressed.

In Embodiment 1-1, the total light transmittance of the printed material 2 is 30% to 70%. When the total light transmittance is 30% or more, when the printed material 2 is placed in front of the solar cell SC, the pattern printed layer 5 becomes difficult to recognize by the light of a screen image, and the image is more clearly recognized. When the total light transmittance is 70% or less, the pattern of the pattern printed layer 5 can be suppressed from appearing dark even if the screen is black.

For example, the relationship may be as follows: "total light transmittance less than 30%: pattern visibility = O, power generation efficiency = ×," "total light transmittance 30% or more and less than 70%: pattern visibility = O, power generation efficiency = ○," and "total light transmittance 70% or more: pattern visibility = ×, power generation efficiency: ○." Here, "pattern visibility" is marked as "○" when the boundary of the solar cell cannot be confirmed at a distance of 1 m when the printed material 2 is overlapped in front of the solar cell, and as "×" when the boundary can be confirmed. "Power generation efficiency" is marked as "○" when the ratio of the power generation amount in the presence of printing to that in the absence of printing is 0.5 or more when the printed material 2 is overlapped in front of the solar cell.

### [Embodiment 1-2]

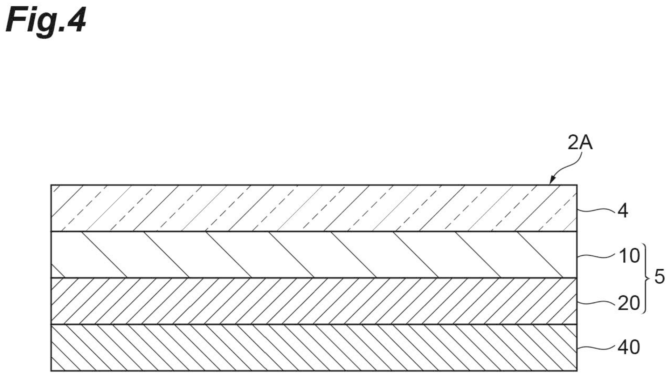

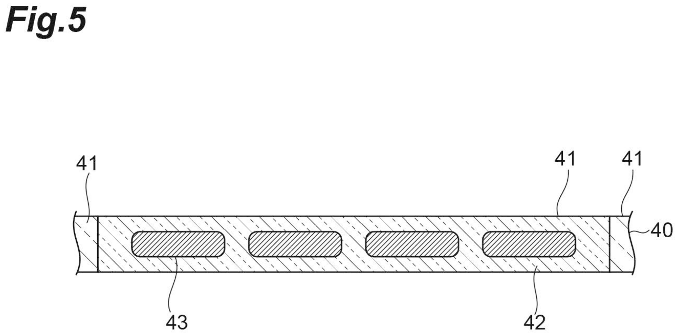

Hereinafter, a printed material 2A according to Embodiment 1-2 will be described with reference to FIGS. 4 and 5. Descriptions overlapping with Embodiment 1-1 above are omitted in the description of Embodiment 1-2, and only parts different from Embodiment 1-1 above will be described. That is, to the extent technically possible, the descriptions of Embodiment 1-1 above may be appropriately applied to Embodiment 1-2.

FIG. 4 is a cross-sectional view schematically showing a printed material according to Embodiment 1-2. FIG. 5 is a cross-sectional view schematically showing a white pattern layer included in the printed material shown in FIG. 4. The printed material 2A includes a light transmissive base material 4 and a pattern printed layer 5. The printed material 2A further includes a white pattern layer 40 provided on the second color pattern layer 20.

The white pattern layer 40 can be provided on the second color pattern layer 20 by, for example, screen printing, inkjet printing, gravure printing, or offset printing. As shown in FIG. 5, the white pattern layer 40 is composed of a plurality of silver dots 41. Here, the term "dot" refers to a point that serves as an element constituting a printed image, and its shape is not limited to a circular shape but may be rectangular, polygonal, or any other shape. Each of the plurality of silver dots 41 includes a silver binder 42 and a plurality of silver pigment chips 43 dispersed within the silver binder 42. A content of the plurality of silver pigment chips 43 is, for example, in a range of 0.5 parts by weight to 20 parts by weight relative to 100 parts by weight of the silver binder 42.

Examples of the silver binder 42 include vinyl resin, acrylic resin, thermoplastic urethane resin, polyester resin, and polycarbonate resin. The thickness of the white pattern layer 40 is, for example, 1 µm to 10 µm. The white pattern layer 40 may contain a curing agent. In this case, the heat resistance of the white pattern layer 40 and the adhesion of the white pattern layer 40 to the second color pattern layer 20 can be improved.

Even with the configuration of the printed material 2A described above, the same operation and effects as those of Embodiment 1-1 above are achieved. Furthermore, In Embodiment 1-2, the printed material includes the white pattern layer 40 provided on the second color pattern layer 20 and composed of the plurality of silver dots 41, in which each of the plurality of silver dots 41 includes the silver binder 42 and the plurality of silver pigment chips 43 dispersed within the silver binder 42. In this case, the color development of the first color pattern layer 10 and the second color pattern layer 20 is excellent, and the pattern printed layer 5 can have a pattern that gives a whitish impression.

### [Embodiment 1-3]

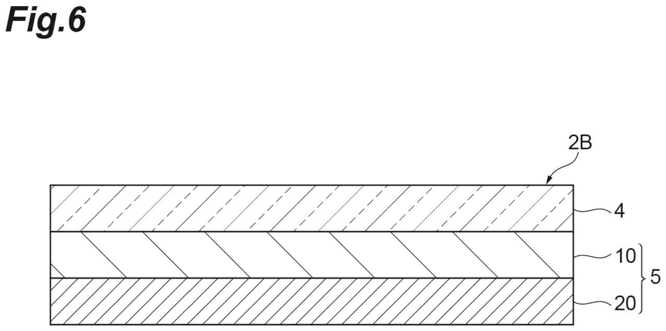

Hereinafter, a printed material 2B according to Embodiment 1-3 will be described with reference to FIG. 6. Descriptions overlapping with Embodiments 1-1 and 1-2 above are omitted in the description of Embodiment 1-3, and only parts different from Embodiments 1-1 and 1-2 above will be described. That is, to the extent technically possible, the descriptions of Embodiments 1-1 and 1-2 above may be appropriately applied to Embodiment 1-3.

FIG. 6 is a cross-sectional view schematically showing a printed material according to Embodiment 1-3. The printed material 2B includes a light transmissive base material 4 and a pattern printed layer 5. That is, the printed material 2B does not include the transmissive smoke-printed layer 30 or the white pattern layer 40. Even with the configuration of the printed material 2B described above, the same operation and effects as those of Embodiment 1-1 above are achieved.

### [Embodiment 1-4]

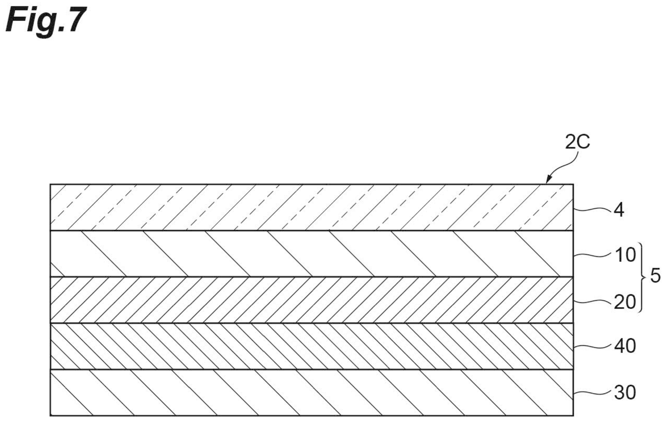

Hereinafter, a printed material 2C according to Embodiment 1-4 will be described with reference to FIG. 7. Descriptions overlapping with Embodiments 1-1, 1-2, and 1-3 above are omitted in the description of Embodiment 1-4, and only parts different from Embodiments 1-1, 1-2, and 1-3 above will be described. That is, to the extent technically possible, the descriptions of Embodiments 1-1, 1-2, and 1-3 above may be appropriately applied to Embodiment 1-4.

FIG. 7 is a cross-sectional view schematically showing a printed material according to Embodiment 1-4. The printed material 2C includes a light transmissive base material 4, a pattern printed layer 5, a white pattern layer 40, and a transmissive smoke-printed layer 30. The white pattern layer 40 is provided on the second color pattern layer 20, and the transmissive smoke-printed layer 30 is provided on the white pattern layer 40. Even with the configuration of the printed material 2C described above, the same operation and effects as those of Embodiments 1, 2, and 3 above are achieved.

The solar cell module according to the present disclosure is not limited to the embodiments described above, and various other modifications are possible. For example, the second color pattern layer may include first interference pigments of multiple colors that generate first interference lights different from each other, and the first color pattern layer may include second interference pigments generating a single-colored second interference light different from the color mixture shown by the plurality of first interference pigments. Furthermore, in each of the embodiments above, the first color pigment chips were first interference pigments of two colors, but the first color pigment chips may be first interference pigments of three or more colors.

### [Second disclosure]

As in the solar cell module disclosed in Japanese Unexamined Patent Publication No. 2021-27266, a printed material may be combined to impart design to a solar cell. There has been a demand for a method to suppress the appearance of the black or dark blue color of the solar cell in the exterior of the solar cell module, in place of or in addition to such a printed material. In addition, since the solar cell module generates power by receiving sunlight, if sunlight is excessively blocked by the printed material, there is a problem that power generation efficiency may decrease.

The present disclosure is to solve the above-described problems, and an object thereof is to provide a solar cell module capable of suppressing the appearance of a black or dark blue color in the exterior of the solar cell module and suppressing a decrease in power generation efficiency.
[1] A solar cell module according to the present disclosure includes: as one aspect, a solar cell; and a vapor deposition layer disposed on a light-receiving surface side of the solar cell and formed by metal vapor deposition.

The above-described solar cell module includes a vapor deposition layer disposed on the light-receiving surface side of the solar cell and formed by metal vapor deposition. The vapor deposition layer has a function of transmitting sunlight necessary for photovoltaic power generation while making a black or dark blue color less visible. Therefore, by disposing the vapor deposition layer on the light-receiving surface side of the solar cell, the appearance of a black or dark blue color in the exterior of the solar cell module can be suppressed. Accordingly, it is possible to suppress the appearance of a black or dark blue color in the exterior of the solar cell module and suppress a decrease in power generation efficiency.
[2] The solar cell module of [1] above further includes: a decorated printed layer disposed on an outer layer side with respect to the light-receiving surface relative to the vapor deposition layer. Accordingly, it is possible to impart design aesthetics to the solar cell module with the printed layer while suppressing the appearance of a black or dark blue color in the exterior of the solar cell module.
[3] The solar cell module of [2] above, in which the printed layer includes a first color pattern layer composed of a plurality of first color dots, and a second color pattern layer provided on the first color pattern layer and composed of a plurality of second color dots, each of the plurality of first color dots includes a first color binder and a plurality of first color pigment chips dispersed within the first color binder, each of the plurality of second color dots includes a second color binder and a plurality of second color pigment chips dispersed within the second color binder, any one of the plurality of first color pigment chips and the plurality of second color pigment chips is first interference pigments of multiple colors that each generate a different first interference light, the other of the plurality of first color pigment chips and the plurality of second color pigment chips is second interference pigments generating a single-colored second interference light different from the color mixture shown by the plurality of first interference pigments, and the plurality of first interference lights and the second interference light are additively mixed. In this case, since any one pattern layer of the first color pattern layer and the second color pattern layer includes interference pigments of multiple colors that generate interference lights different from each other, a three-dimensional pattern expression can be realized even with a small number of printed layers. Furthermore, in this printed material, the pattern layer including the interference pigments that generate a plurality of interference lights may be any one layer of the first color pattern layer and the second color pattern layer, so that color matching and registration work during printing can be simplified. Therefore, according to this printed material, a three-dimensional pattern can be expressed even with a small number of printed layers, and color matching and registration work during printing can be simplified. In addition, the printed material can suppress a decrease in power generation efficiency of the solar cell module by ensuring transmissivity to sunlight for the solar cell while obtaining these effects.
[4] The solar cell module of any one of [1] to [3] above may further include: a film layer as an outermost layer with respect to the light-receiving surface. In this case, the surface of the solar cell module can be protected by the film layer. In addition, by using the film layer as the outermost layer, the vapor-deposited surface can be protected. In the case of having a printed layer, it is possible to obtain the advantage of protecting the printed layer, which is composed of color pigment chips and has gaps, making it fragile.
[5] The solar cell module of any one of [1] to [3] above may further include: a top coat layer as an outermost layer with respect to the light-receiving surface. In this case, the surface of the solar cell module can be protected by the top coat layer. In addition, by using the top coat layer as the outermost layer, it is possible to easily adjust glossiness and obtain the advantage of reducing scratches during installation.
[6] The solar cell module of any one of [1] to [3] above may further include: a glass layer as an outermost layer with respect to the light-receiving surface. In this case, the surface of the solar cell module can be protected by the glass layer. In addition, by using the glass layer as the outermost layer, it is possible to obtain the advantage of delaying degradation due to excellent gas barrier properties.
[7] In the solar cell module of any one of [1] to [6] above, the total light transmittance of the vapor deposition layer may be 25% to 75%. In this case, the appearance of a black or dark blue color in the exterior of the solar cell module can be suppressed. Meanwhile, it is possible to suppress an excessive decrease in power generation efficiency of the solar cell.

According to the present disclosure, it is possible to provide a solar cell module capable of suppressing the appearance of a black or dark blue color in the exterior of the solar cell module and suppressing a decrease in power generation efficiency.

Specific examples of the solar cell module according to embodiments of the present disclosure will be described below with reference to the drawings. The present disclosure is not limited to these examples, and is indicated by the claims, and it is intended that all modifications within the meaning and scope equivalent to the claims are included. In the following description, the same elements are denoted by the same reference numerals in the description of the drawings, and redundant descriptions are omitted.

### [Embodiment 2-1]

Generally, since the surface of a solar cell embedded in a solar cell module only exhibits a black or dark blue color, attempts have been made to variously color the exterior of the solar cell module for the purpose of improving its design aesthetics. In the present embodiment, a printed material is applied to the surface of the solar cell module in a manner capable of improving the design aesthetics of the solar cell module's exterior while significantly suppressing a decrease in the power generation amount of the solar cell.

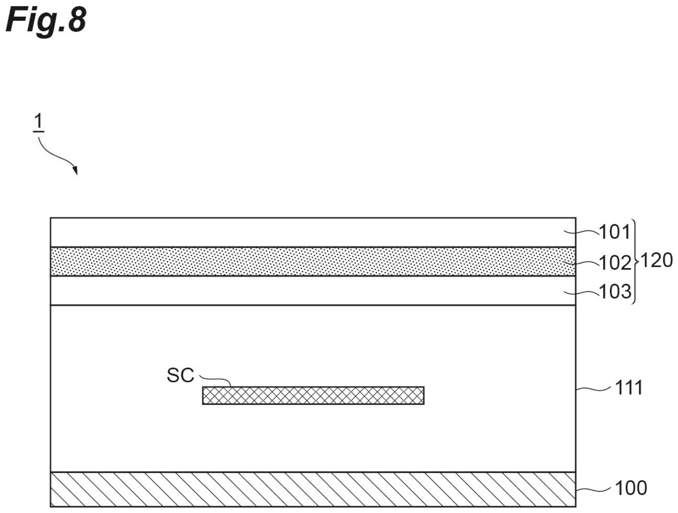

FIG. 8 is a cross-sectional view schematically showing a solar cell module according to Embodiment 2-1. As shown in FIG. 8, the solar cell module 1 includes a back surface material 100, a sealing material layer 111, a solar cell SC, and a surface layer 120. The surface layer 120 includes a film layer 101, a vapor deposition layer 102, and an adhesive layer 103. A thin plate-shaped solar cell SC is placed on the back surface material 100 in a state embedded in the sealing material layer 111 with its light-receiving surface facing upward. The surface layer 120 is formed on the light-receiving surface side of the solar cell SC.

The solar cell SC may be a photoelectric conversion element formed in a thin plate shape with a thickness of about 0.2 mm, such as crystalline or amorphous silicon, thin-film silicon, perovskite-based materials, chalcopyrite-based materials, group III-V based materials, CdTe, or CIS, and may generate power by absorbing light having a wavelength mainly in the visible light region. The sealing material layer 111 may be made of a transparent material such as ethylene vinyl acetate (EVA), polyvinyl butyral (PVB), polyolefin resin, ionomer resin, or silicone resin, and may be formed to surround the solar cell SC, as shown in the drawing, in a layered shape with a thickness of about 1 mm.

The back surface material 100 may be formed of polyethylene terephthalate (PET), a polycarbonate resin, an acrylic resin, glass, or a metal (such as aluminum) in a layered, film-like, or plate-like shape. Adhesion between the back surface material 100 and the sealing material layer 111 may be achieved by the adhesive force of the sealing material layer 111.

The vapor deposition layer 102 is a layer disposed on the light-receiving surface side of the solar cell SC and formed by metal vapor deposition. The vapor deposition layer 102 is a layer for transmitting sunlight for the solar cell SC while concealing the black or dark blue color on the solar cell SC side. As the metal for the vapor deposition layer 102, aluminum, indium, tin, zinc, chromium, nickel, gold, silver, or the like may be used. When aluminum is adopted as the metal for the vapor deposition layer, there is an advantage of being inexpensive. When indium is adopted as the metal for the vapor deposition layer 102, there is an advantage of excellent durability. When tin is adopted as the metal for the vapor deposition layer, there is an advantage of non-conductivity. One that has been previously formed into a film by vapor deposition may be adopted as the vapor deposition layer 102. Alternatively, it may be formed by performing a sputtering process or the like on other components (here, the film layer 101) of the surface layer 120. The thickness of the vapor deposition layer 102 may be 10 to 100 nm, preferably 15 to 60 nm, and more preferably 20 to 50 nm.

In the present embodiment, the film layer 101 is disposed as the outermost layer with respect to the solar cell SC. The film layer 101 is disposed on the main surface on the outer layer side of the vapor deposition layer 102. The film layer 101 has a function of protecting other members (here, the vapor deposition layer 102) of the surface layer 120. As a material of the film layer 101, for example, acrylic resin, fluororesin, polypropylene resin, polyester resin, or the like may be adopted. The thickness of the film layer 101 may be 30 to 200 µm, preferably 40 to 180 µm, and more preferably 50 to 150 µm.

The adhesive layer 103 is disposed between the main surface of the sealing material layer 111 and the vapor deposition layer 102. The adhesive layer 103 is a layer for adhering the vapor deposition layer 102 to the main surface of the sealing material layer 111. As a material of the film layer 101, for example, silicone resin, acrylic resin, epoxy resin, or the like may be adopted. The thickness of the adhesive layer 103 may be 30 to 300 µm, preferably 40 to 200 m, and more preferably 50 to 150 µm.

Here, the total light transmittance will be described. The total light transmittance of the vapor deposition layer 102 may be 25% to 75%. In particular, in order to suppress a decrease in power generation efficiency of the solar cell module 1, the total light transmittance of the vapor deposition layer 102 may be 25% or more. In addition, in order to suppress the black or dark blue color appearing on the exterior of the solar cell module 1, the total light transmittance of the vapor deposition layer 102 may be 75% or less. The total light transmittance referred to herein means a value measured using a spectrophotometer (for example, Spectrophotometer UV-3600 manufactured by Shimadzu Corporation).

Next, the operation and effects of the solar cell module 1 according to the present embodiment will be described.

The solar cell module 1 according to the present embodiment includes the vapor deposition layer 102 disposed on the light-receiving surface side of the solar cell SC and formed by metal vapor deposition. The vapor deposition layer 102 has a function of transmitting sunlight necessary for photovoltaic power generation while making a black or dark blue color due to the solar cell SC or the like less visible. Therefore, by disposing the vapor deposition layer 102 on the light-receiving surface side of the solar cell SC, the appearance of a black or dark blue color in the exterior of the solar cell module 1 can be suppressed. Accordingly, it is possible to suppress the appearance of a black or dark blue color in the exterior of the solar cell module 1 and suppress a decrease in power generation efficiency.

The solar cell module 1 may include the film layer 101 as the outermost layer with respect to the light-receiving surface. In this case, the surface of the solar cell module 1 can be protected by the film layer 101. In addition, by using the film layer 101 as the outermost layer, the vapor-deposited surface can be protected. In the case of having a printed layer 202 described below, it is possible to obtain the advantage of protecting the printed layer 202, which is composed of color pigment chips and has gaps, making it fragile.

In the solar cell module 1, the total light transmittance of the vapor deposition layer 102 may be 25% to 75%. In this case, the appearance of a black or dark blue color in the exterior of the solar cell module 1 can be suppressed. Meanwhile, it is possible to suppress an excessive decrease in power generation efficiency of the solar cell SC.

### [Embodiment 2-2]

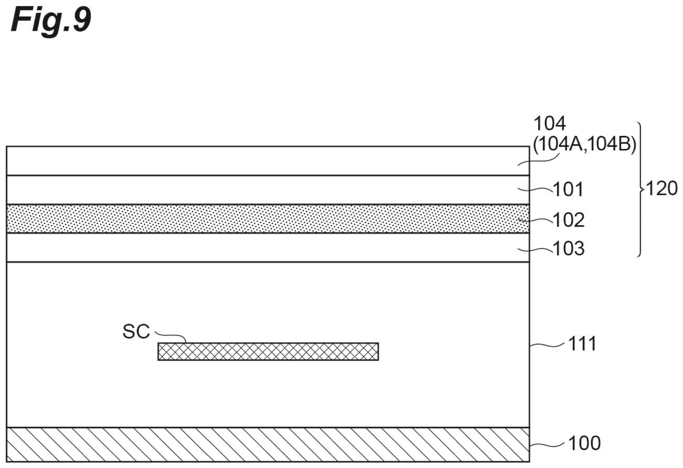

Hereinafter, a solar cell module 1 according to Embodiment 2-2 will be described with reference to FIG. 9. Descriptions overlapping with Embodiment 2-1 above are omitted in the description of Embodiment 2-2, and only parts different from Embodiment 2-1 above will be described. That is, to the extent technically possible, the descriptions of Embodiment 2-1 above may be appropriately applied to Embodiment 2-2.

FIG. 9 is a cross-sectional view schematically showing a solar cell module 1 according to Embodiment 2-2. As shown in FIG. 9, the solar cell module 1 according to Embodiment 2-2 includes a protective layer 104 further on the outer layer of the film layer 101.

As the protective layer 104, a top coat layer 104A may be adopted. The top coat layer 104A may be, for example, similar to those applied to painted surfaces of vehicles or the like. The thickness of the top coat layer 104A may be 5 to 50 µm, preferably 10 to 40 µm, and more preferably 15 to 30 µm. As a material of the top coat layer 104A, an active energy ray-curable coating composition hardened by ultraviolet irradiation, an electron beam, or the like, or a thermosetting coating composition and the like may be used.

In this manner, the solar cell module 1 may include the top coat layer 104A as the outermost layer with respect to the light-receiving surface. In this case, the surface of the solar cell module 1 can be protected by the top coat layer 104A. In addition, by using the top coat layer 104A as the outermost layer, it is possible to easily adjust glossiness and obtain the advantage of reducing scratches during installation. Further, it is possible to obtain the advantage of protecting the film layer 101 from ultraviolet rays.

In addition, as the protective layer 104, a glass layer 104B may be adopted. As the glass layer 104B, for example, various types of glass such as soda-lime glass and aluminoborosilicate glass are adopted, and the thickness of the glass layer 104B may be 2.0 to 5.0 mm, preferably 2.5 to 4.0 mm, and more preferably 2.5 to 3.0 mm.

The solar cell module 1 may include the glass layer 104B as the outermost layer with respect to the light-receiving surface. In this case, the surface of the solar cell module 1 can be protected by the glass layer 104B. In addition, by using the glass layer 104B as the outermost layer, it is possible to obtain the advantage of delaying degradation due to excellent gas barrier properties. Further, it is possible to obtain the advantage of protecting the film layer 101 from scratches.

### [Embodiment 2-3]

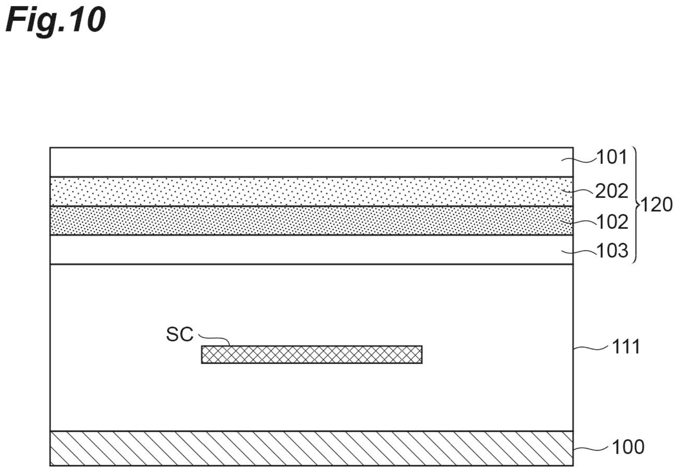

Hereinafter, a solar cell module 1 according to Embodiment 2-3 will be described with reference to FIG. 10. Descriptions overlapping with Embodiment 2-1 and 2-2 above are omitted in the description of Embodiment 2-3, and only parts different from Embodiment 2-1 and 2-2 above will be described. That is, to the extent technically possible, the descriptions of Embodiment 2-1 and 2-2 above may be appropriately applied to Embodiment 2-3.

FIG. 10 is a cross-sectional view schematically showing a solar cell module 1 according to Embodiment 2-3. As shown in FIG. 10, the solar cell module 1 according to Embodiment 2-3 includes a decorated printed layer 202 between the vapor deposition layer 102 and the film layer 101.

The printed layer 202 has the same configuration as the above-described printed materials 2, 2A, 2B, and 2C. In addition, the transmissive smoke-printed layer 30 may be omitted from the printed layer 202.

The total light transmittance of the printed layer 202 is, for example, 50% to 80%. In particular, it may be 60% or more to suppress a decrease in power generation efficiency of the solar cell module 1. The total light transmittance referred to herein means a value measured using a spectrophotometer (for example, Spectrophotometer UV-3600 manufactured by Shimadzu Corporation).

Accordingly, the solar cell module further includes: a decorated printed layer disposed on an outer layer side with respect to the light-receiving surface relative to the vapor deposition layer. Accordingly, it is possible to impart design aesthetics to the solar cell module with the printed layer while suppressing the appearance of a black or dark blue color in the exterior of the solar cell module.

The total light transmittance of the printed layer 202 is 50% to 80%. When the total light transmittance is 60% or more, when the printed layer 202 is placed in front of the solar cell SC, the pattern printed layer 5 becomes difficult to recognize by the light of a screen image, and the image is more clearly recognized. When the total light transmittance is 80% or less, the pattern of the pattern printed layer 5 can be suppressed from appearing dark even if the screen is black.

In addition, the printed layer may be formed by a pigment. As pigments, inorganic pigments such as titanium oxide, zinc white, carbon black, iron composite oxides, iron oxide, and ultramarine, and organic pigments such as isoindolinone, disazo, polyazo, diketopyrrolopyrrole, quinacridone, and phthalocyanine may be used.

### [Embodiment 2-4]

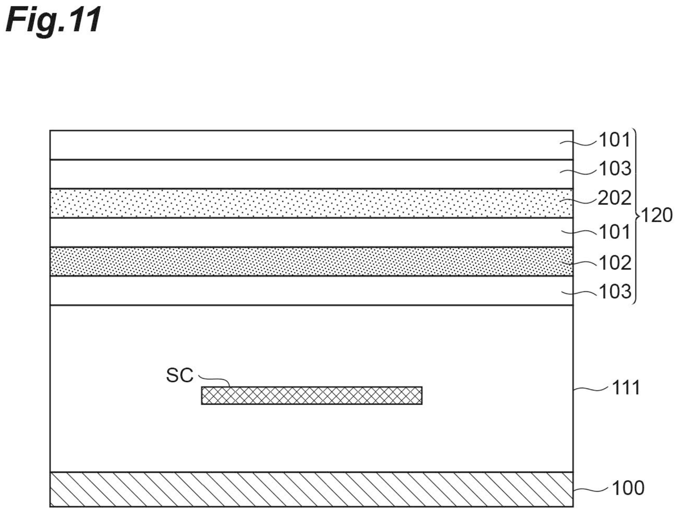

Hereinafter, a solar cell module 1 according to Embodiment 2-4 will be described with reference to FIG. 11. Descriptions overlapping with Embodiments 2-1 to 2-3 above are omitted in the description of Embodiment 2-4, and only parts different from Embodiments 2-1 to 2-3 above will be described. That is, to the extent technically possible, the descriptions of Embodiments 2-1 to 2-3 above may be appropriately applied to Embodiment 2-4.

FIG. 11 is a cross-sectional view schematically showing a solar cell module 1 according to Embodiment 2-4. As shown in FIG. 11, the solar cell module 1 according to Embodiment 2-4 includes a film layer 101 between the vapor deposition layer 102 and the printed layer 202 in addition to the solar cell module 1 according to Embodiment 2-3, and further includes an adhesive layer 103 between the printed layer 202 and a film layer 101 which is the outermost layer. The film layer 101 and the adhesive layer 103 may have the same configuration as the film layer 101 and the adhesive layer 103 in Embodiment 2-1.

According to such a configuration, the film layer 101 is interposed between the vapor deposition layer 102 and the printed layer 202. The printed layer 202 is protected by being sandwiched between a pair of film layers 101. In this case, there is an advantage of protecting the vapor deposition layer 102 from a solvent contained in an ink when forming the printed layer 202, as compared to the structure of FIG. 11 described below.

### [Embodiment 2-5]

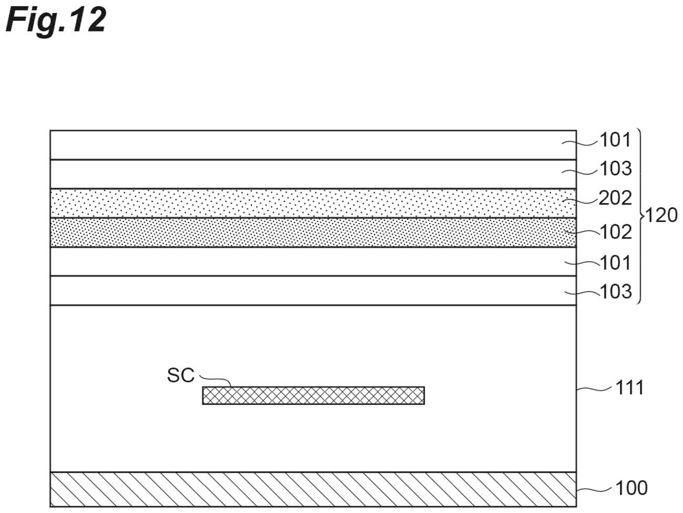

Hereinafter, a solar cell module 1 according to Embodiment 2-5 will be described with reference to FIG. 12. Descriptions overlapping with Embodiments 2-1 to 2-4 above are omitted in the description of Embodiment 2-5, and only parts different from Embodiments 2-1 to 2-4 above will be described. That is, to the extent technically possible, the descriptions of Embodiments 2-1 to 2-4 above may be appropriately applied to Embodiment 2-5.

FIG. 12 is a cross-sectional view schematically showing a solar cell module 1 according to Embodiment 2-5. As shown in FIG. 12, the solar cell module 1 according to Embodiment 2-5 is different from the solar cell module 1 according to Embodiment 2-5 in that the lamination order of the vapor deposition layer 102 and the film layer 101 is interchanged. Accordingly, the printed layer 202 and the vapor deposition layer 102 are arranged adjacent to each other.

According to such a configuration, the vapor deposition layer 102 and the printed layer 202 are in an interposed configuration in which they are in contact with each other. The printed layer 202 and the vapor deposition layer 102 are protected by being sandwiched between a pair of film layers 101. In this case, there is an advantage of protecting the vapor deposition layer 102 and the printed layer 202 from a solvent contained in the adhesive when forming the adhesive layer 103, as compared to the structure of FIG. 11 described above.

### [Third disclosure]

When installing a solar cell module on a wall, conventional solar cell modules (for example, Japanese Unexamined Patent Publication No. 2021-027266) lack sufficient design aesthetics, and improvement is desired.

An object of the present disclosure is to provide a solar cell module with improved design aesthetics.
[1] The present disclosure relates to, as one aspect, a solar cell module including: at least one solar cell; and a printed material disposed on a light-receiving surface side of the solar cell and having a pattern printed layer. The pattern printed layer includes a first color pattern layer composed of a plurality of first color dots, and a second color pattern layer provided so as to overlap with the first color pattern layer and composed of a plurality of second color dots. Each of the plurality of first color dots includes a first color binder and a plurality of first color pigment chips dispersed within the first color binder, and each of the plurality of second color dots includes a second color binder and a plurality of second color pigment chips dispersed within the second color binder. Any one of the plurality of first color pigment chips and the plurality of second color pigment chips is first interference pigments of multiple colors that generate first interference lights different from each other, and the other of the plurality of first color pigment chips and the plurality of second color pigment chips is second interference pigments generating a single-colored second interference light different from the color mixture shown by the first interference pigments of multiple colors. At least one of the first interference pigments and the second interference pigment includes a small particle size grade interference pigment including a particle size range of 5 µm to 25 µm and a large particle size grade interference pigment including a particle size range of 25 µm to 40 µm. In the pattern printed layer of this solar cell module, the small particle size grade interference pigment is disposed to fill gaps between the large particle size grade interference pigments, and the plurality of first interference lights and the second interference light are additively mixed.

According to the study by the present inventors, it was found that when the particle size of the interference pigments included in the pattern printed layer is small, although the color development is weak, it is possible to suppress the pattern from looking dark even if the printed material is placed in front of a solar cell of a black color or the like. On the other hand, it was found that when the particle size of the interference pigments included in the pattern printed layer is large, the transparency of the printed material increases, and the color development of the pattern can be made excellent. Therefore, the present inventors have come up with a solar cell module having a printed material with excellent color development of the pattern while suppressing the pattern from looking dark, by configuring the interference pigments to include a small particle size grade interference pigment and a large particle size grade interference pigment, and by disposing the small particle size grade interference pigment so as to fill gaps between the large particle size grade interference pigments. Therefore, according to the solar cell module having the above-described configuration, it is possible to provide a pattern with excellent visibility and color development, and to improve design aesthetics. Furthermore, in this solar cell module, by including the large particle size grade interference pigments, a decrease in transparency of the pattern printed layer is suppressed. Therefore, according to this solar cell module, a decrease in transmitted light to the solar cell is favorably suppressed, and power generation efficiency can be maintained.
[2] In the solar cell module of [1] above, the large particle size grade interference pigments may include a particle size range of 25 µm to 60 µm. In this case, the color development of the pattern can be made superior.
[3] In the solar cell module of [1] or [2] above, at least one of the small particle size grade interference pigments and the large particle size grade interference pigments may be interference pigments including titanium dioxide-coated mica. In this case, the wavelength of the interference lights can be adjusted by adjusting the film thickness and transmittance of the titanium dioxide film. In addition, by increasing the smoothness of the mica surface, the sense of brightness can be improved.
[4] In the solar cell module of any one of [1] to [3] above, the printed material may further include a light transmissive base material provided on the first color pattern layer. In this case, the pattern printed layer can be protected without decreasing the transmitted light to the solar cell.
[5] In the solar cell module of any one of [1] to [4] above, the printed material may further include a white pattern layer composed of a plurality of silver dots, and each of the plurality of silver dots may include a silver binder and a plurality of silver pigment chips dispersed within the silver binder. The second color pattern layer may be provided on the white pattern layer. In this case, the color development of the first color pattern layer and the second color pattern layer is superior, and the pattern printed layer can have a pattern that gives a whitish impression.
[6] In the solar cell module of any one of [1] to [5] above, the printed material may further include a transmissive smoke-printed layer provided between the pattern printed layer and the solar cell. In this case, the color development of the first color pattern layer and the second color pattern layer is superior. Furthermore, because the transmissive smoke-printed layer has transmissivity, a decrease in transmitted light to the solar cell is favorably suppressed.
[7] In the solar cell module of any one of [1] to [6] above, each thickness of the first color pattern layer and the second color pattern layer may be 10 µm or less. In this case, a decrease in transmitted light to the solar cell is favorably suppressed.
[8] In the solar cell module of any one of [1] to [7] above, both the first interference pigments and the second interference pigments may include a small particle size grade interference pigment including a particle size range of 5 µm to 25 µm and a large particle size grade interference pigment including a particle size range of 25 µm to 40 µm. In this case, it is possible to further improve the design aesthetics of the solar cell module, and a decrease in transmitted light to the solar cell is favorably suppressed.

According to the present disclosure, it is possible to provide a solar cell module with improved design aesthetics.

Specific examples of the solar cell module according to embodiments of the present disclosure will be described below with reference to the drawings. The present disclosure is not limited to these examples, and is indicated by the claims, and it is intended that all modifications within the meaning and scope equivalent to the claims are included. In the following description, the same elements are denoted by the same reference numerals in the description of the drawings, and redundant descriptions are omitted.

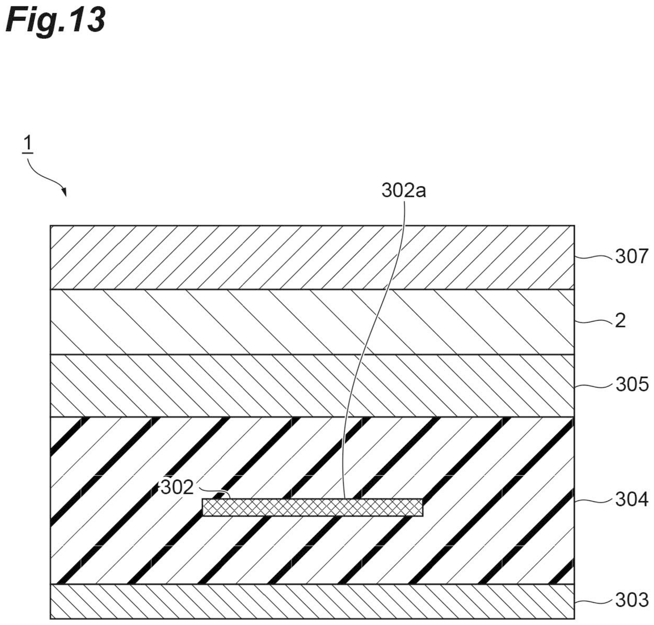

FIG. 13 is a cross-sectional view schematically showing a solar cell module according to one embodiment. As shown in FIG. 13, a solar cell module 1 includes a thin plate-shaped solar cell 302, a back surface material 303, a sealing material layer 304, a surface plate 305, and a printed material 2. The solar cell module 1 may further include a hard coat layer 307 on the surface side of the printed material 2.

The solar cell 302 is a photoelectric conversion element formed in a thin plate shape with a thickness of about 0.2 mm, such as crystalline or amorphous silicon, thin-film silicon, perovskite-based materials, chalcopyrite-based materials, group III-V based materials, CdTe, or CIS, and may generate power by absorbing light having a wavelength mainly in the visible light region. The solar cell 302 is embedded (sealed) in the sealing material layer 304 so that its light-receiving surface 2a faces the printed material 2. The light-receiving surface 302a of the solar cell 302 has a black or dark blue color. In the example shown in FIG. 13, only one solar cell 302 is shown, but the solar cell module 1 can be provided with a plurality of solar cells 302.

The back surface material 303 is a member in which polyethylene terephthalate, a polycarbonate resin, an acrylic resin, glass, or a metal (such as aluminum) is formed in a layered, film-like, or plate-like shape. The sealing material layer 304 is formed on such a back surface material 303.

The sealing material layer 304 is a layer formed from a transparent sealing material such as ethylene vinyl acetate (EVA), polyvinyl butyral (PVB), polyolefin resin, ionomer resin, or silicone resin. The sealing material layer 304 is formed by sealing the above-described solar cell 302 so as to surround it with a transparent sealing material. The thickness of the sealing material layer 304 is, for example, about 1 mm.

The surface plate 305 is a transparent plate-like member disposed on the sealing material layer 304 to protect the solar cell 302. The surface plate 305 is provided to face the light-receiving surface 2a of the solar cell 302. The surface plate 305 is formed from a transparent material such as a polycarbonate resin, an acrylic resin, or glass. The thickness of the surface plate 305 is, for example, about 3 mm. The back surface material 303 and the surface plate 305 may each be fixed to the sealing material layer 304 by the adhesive force of the sealing material (such as resin) that constitutes the sealing material layer 304, or may each be fixed to the sealing material layer 304 by an individual transparent adhesive.

The printed material 2 is a member for imparting design aesthetics to the solar cell module. The printed material 2 is attached to the surface side of the surface plate 305 with a transparent adhesive or the like. The details of the printed material 2 will be described below.

The hard coat layer 307 is a coat layer for protecting the printed material 2. The thickness of the hard coat layer 307 may be, for example, 5 to 50 µm, preferably 10 to 40 µm, and more preferably 15 to 30 µm. The hard coat layer 307 may be formed, for example, from an active energy ray-curable coating composition hardened by ultraviolet irradiation or an electron beam, or a thermosetting coating composition.

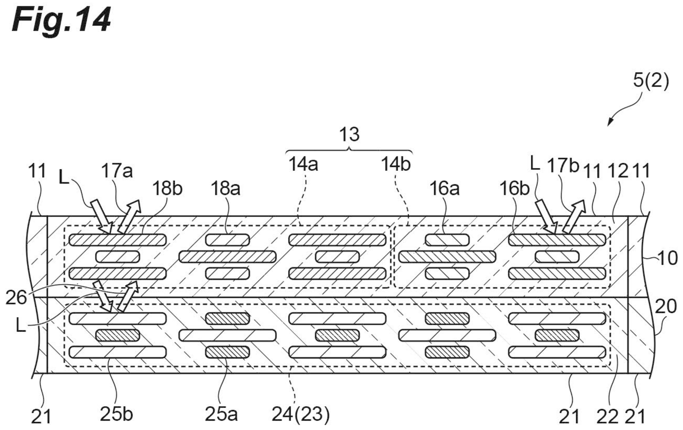

FIG. 2 shows a cross-sectional view schematically showing the printed material provided in the solar cell module shown in FIG. 13. FIG. 14 is a cross-sectional view schematically showing a pattern printed layer provided in the printed material in the third disclosure. As shown in FIG. 2, the printed material 2 is a sheet for expressing a pattern and includes a light transmissive base material 4, a pattern printed layer 5, and a transmissive smoke-printed layer 30. The printed material 2 is provided in front of the solar cell 302. The printed material 2 has total light transmittance. For this reason, when sunlight enters the solar cell module 1 through the printed material 2, the solar cell 302 can generate power from the sunlight. In addition, the pattern expressed by the printed material 2 can be visually recognized.

The first color pattern layer 10 can be provided on the surface 4a of the light transmissive base material 4 by, for example, screen printing, inkjet printing, gravure printing, or offset printing. As shown in FIG. 14, the first color pattern layer 10 is composed of a plurality of first color dots 11. Here, the term "dot" refers to a point that serves as an element constituting a printed image, and its shape is not limited to a circular shape but may be rectangular, polygonal, or any other shape. Each of the plurality of first color dots 11 includes a first color binder 12 and a plurality of first color pigment chips 13 dispersed within the first color binder 12. A content of the plurality of first color pigment chips 13 is, for example, in a range of 0.5 parts by weight to 20 parts by weight relative to 100 parts by weight of the first color binder 12.

Examples of the first color binder 12 include vinyl resin, acrylic resin, thermoplastic urethane resin, polyester resin, and polycarbonate resin. The thickness of the first color pattern layer 10 is, for example, 1 µm to 10 µm. The first color pattern layer 10 may contain a curing agent. In this case, the heat resistance of the first color pattern layer 10 and the adhesion of the first color pattern layer 10 to the light transmissive base material 4 can be improved.

The plurality of first color pigment chips 13 are first interference pigments 14a and 14b of multiple colors that generate interference lights different from each other. Each of the first interference pigments 14a and 14b is composed of a flake (not shown) having visible light transmissivity and a metal oxide film (not shown) coating the flake. Of the incident light from the light transmissive base material 4 side to the first color pattern layer 10, light reflected at the surface of the metal oxide film and light passing through the metal oxide film and reflected at the surface of the flake interfere with each other, generating interference light. By adjusting the film thickness and the refractive index of the metal oxide film, interference light having a desired wavelength can be generated.

Each of the first interference pigments 14a and 14b is, for example, titanium dioxide-coated mica. Flakes constituting the first interference pigments 14a and 14b may be other than mica, for example, silica, alumina, glass, or polysilicate. The metal oxide film constituting the first interference pigments 14a and 14b may be other than titanium dioxide, for example, zirconium oxide, zinc oxide, iron oxide, or tin oxide.

The first interference pigment 14a includes a plurality of first titanium dioxide-coated mica particles 18a of a small particle size grade having a particle size range of 5 µm to 25 µm, and a plurality of second titanium dioxide-coated mica particles 18b of a large particle size grade having a particle size range of 25 µm to 40 µm. The first interference pigment 14b includes a plurality of first titanium dioxide-coated mica particles 16a of a small particle size grade having a particle size range of 5 µm to 25 µm, and a plurality of second titanium dioxide-coated mica particles 16b of a large particle size grade having a particle size range of 25 µm to 40 µm. The average particle size (D50) of the first titanium dioxide-coated mica particles 18a and 16a is, for example, about 15 µm, and the average particle size (D50) of the second titanium dioxide-coated mica particles 18b and 16b is, for example, about 25 µm. As a result, the average particle size of the first titanium dioxide-coated mica particles 18a and 16a is smaller than the average particle size of the second titanium dioxide-coated mica particles 18b and 16b. The second titanium dioxide-coated mica particles 18b and 16b may include a particle size range of 25 µm to 60 µm. In this case, the average particle size (D50) of the second titanium dioxide-coated mica particles 18b and 16b is, for example, about 35 µm. As shown in FIG. 2, each of the plurality of first titanium dioxide-coated mica particles 18a and 16a is disposed to fill gaps between the plurality of second titanium dioxide-coated mica particles 18b and 16b. Here, "particle size" means the longest diameter of a particle cross section.

Each of first interference lights 17a and 17b different from each other is generated from each of the first interference pigments 14a and 14b by incident light L incident on the first color pattern layer 10. That is, the wavelengths of the first interference lights 17a and 17b are different from each other. Accordingly, the first interference pigments 14a and 14b exhibit a color mixture. Each of the first interference pigments 14a and 14b may be, for example, a red interference pigment (red pearl pigment) and a gold interference pigment (gold pearl pigment). In this case, each of the first interference lights 17a and 17b exhibits red and gold. Each of the first interference pigments 14a and 14b may be an interference pigment of another color. The blending amounts of the first interference pigments 14a and 14b may be the same or different from each other.

The second color pattern layer 20 can be provided on the first color pattern layer 10 by, for example, screen printing, inkjet printing, gravure printing, or offset printing. As shown in FIG. 14, the second color pattern layer 20 is composed of a plurality of second color dots 21. Here, the term "dot" refers to a point that serves as an element constituting a printed image, and its shape is not limited to a circular shape but may be rectangular, polygonal, or any other shape. Each of the plurality of second color dots 21 includes a second color binder 22 and a plurality of second color pigment chips 23 dispersed within the second color binder 22. A content of the plurality of second color pigment chips 23 is, for example, in a range of 0.5 parts by weight to 20 parts by weight relative to 100 parts by weight of the second color binder 22.

Examples of the second color binder 22 include vinyl resin, acrylic resin, thermoplastic urethane resin, polyester resin, and polycarbonate resin. The thickness of the second color pattern layer 20 is, for example, 1 µm to 10 µm. The second color pattern layer 20 may contain a curing agent. In this case, the heat resistance of the second color pattern layer 20 and the adhesion of the second color pattern layer 20 to the first color pattern layer 10 can be improved.

The plurality of second color pigment chips 23 are second interference pigments 24 generating a single-colored interference light different from the color mixture shown by the first interference pigments 14a and 14b. The second interference pigments 24 are composed of a flake (not shown) having visible light transmissivity and a metal oxide film (not shown) coating the flake. Of the incident light from the light transmissive base material 4 side to the second color pattern layer 20, light reflected at the surface of the metal oxide film and light passing through the metal oxide film and reflected at the surface of the flake interfere with each other, generating interference light. By adjusting the film thickness and the refractive index of the metal oxide film, interference light having a desired wavelength can be generated.

The second interference pigments 24 are, for example, titanium dioxide-coated mica. The flake constituting the second interference pigments 24 may be other than mica, for example, silica, alumina, glass, or polysilicate. The metal oxide film constituting the second interference pigments 24 may be other than titanium dioxide, for example, zirconium oxide, zinc oxide, iron oxide, or tin oxide.

The second interference pigments 24 include a plurality of first titanium dioxide-coated mica particles 25a of a small particle size grade having a particle size range of 5 µm to 25 µm, and a plurality of second titanium dioxide-coated mica particles 25b of a large particle size grade having a particle size range of 25 µm to 40 µm. The average particle size (D50) of the first titanium dioxide-coated mica particles 25a, for example, about 15 µm, and the average particle size (D50) of the second titanium dioxide-coated mica particles 25b is, for example, about 25 µm. Accordingly, the average particle size of the first titanium dioxide-coated mica particles 25a is smaller than the average particle size of the second titanium dioxide-coated mica particles 25b. The second titanium dioxide-coated mica particles 25b may include a particle size range of 25 µm to 60 µm. In this case, the average particle size (D50) of the second titanium dioxide-coated mica particles 25b is, for example, about 35 µm. Each of the plurality of first titanium dioxide-coated mica particles 25a is disposed to fill gaps between the plurality of second titanium dioxide-coated mica particles 25b. Here, "particle size" means the longest diameter of a particle cross section.

From the second interference pigments 24, a single-colored second interference light 26 is generated when incident light L is incident on the second color pattern layer 20. Accordingly, the second interference pigments 24 exhibit a single color. The second interference pigments 24 may be interference pigments that generate a single-colored second interference light 26 different from the color mixture shown by the first interference pigments 14a and 14b, and may be, for example, green interference pigments (green pearl pigments). In this case, the second interference light 26 exhibits green. The second interference pigments 24 may be interference pigments of a color other than green.

The transmissive smoke-printed layer 30 is a layer for attenuating the light transmitted through the printed material 2 within a range that does not affect photovoltaic power generation. The transmissive smoke-printed layer 30 is provided on the outermost surface opposite to the light transmissive base material 4 with respect to the pattern printed layer 5. In first embodiment, the transmissive smoke-printed layer 30 is provided on (downward in the drawing) the second color pattern layer 20 as shown in FIG. 2. The transmissive smoke-printed layer 30 can be provided on the second color pattern layer 20 by, for example, screen printing, inkjet printing, gravure printing, or offset printing using ink in which a small amount of carbon black is dispersed in, for example, a vinyl-based, acrylic-based, urethane-based, or polyester-based resin binder. The thickness of the transmissive smoke-printed layer 30 is, for example, 1 µm to 10 µm.

In the printed material 2, a pattern for design aesthetics is expressed by additively mixing the first interference lights 17a and 17b generated by the first interference pigments 14a and 14b with the second interference light 26 generated by the second interference pigments 24.

The total light transmittance of the printed material 2 is, for example, 30% to 70%. The total light transmittance referred to herein means a value measured using a spectrophotometer (for example, Spectrophotometer UV-2100 manufactured by Shimadzu Corporation). The light referred to here is within a wavelength range of 380 nm to 780 nm.

In the solar cell module 1 according to the present embodiment described above, in the first color pattern layer 10 of the pattern printed layer 5 of the printed material 2, each of the plurality of first titanium dioxide-coated mica particles 18a and 16a of a small particle size grade including a particle size range of 5 µm to 25 µm is disposed so as to fill gaps between the plurality of second titanium dioxide-coated mica particles 18b and 16b of a large particle size grade including a particle size range of 25 µm to 40 µm. In the printed material 2, in the second color pattern layer 20, each of the plurality of first titanium dioxide-coated mica particles 25a of a small particle size grade including a particle size range of 5 µm to 25 µm is disposed so as to fill gaps between the plurality of second titanium dioxide-coated mica particles 25b of a large particle size grade including a particle size range of 25 µm to 40 µm. According to this solar cell module 1, it is possible to provide a pattern with excellent visibility and color development, and to improve design aesthetics. Furthermore, in this solar cell module 1, the first color pattern layer 10 includes the second titanium dioxide-coated mica particles 18b and 16b of a large particle size grade, and the second color pattern layer 20 includes the second titanium dioxide-coated mica particles 25b of a large particle size grade. Accordingly, a decrease in transparency of the pattern printed layer 5 is suppressed. Therefore, according to the solar cell module 1, a decrease in transmitted light to the solar cell 302 is favorably suppressed, and power generation efficiency can be maintained.

In the solar cell module 1 according to the present embodiment, the second titanium dioxide-coated mica particles 18b, 16b, and 25b of a large particle size grade may be configured to include a particle size range of 25 µm to 60 µm. In this case, the color development of the pattern is superior. In addition, power generation efficiency can be further maintained.

In the solar cell module 1 according to the present embodiment, the first interference pigments 14a and 14b and the second interference pigments 24 are interference pigments including titanium dioxide-coated mica. Therefore, the wavelength of the interference lights can be adjusted by adjusting the film thickness and transmittance of the titanium dioxide film. In addition, by increasing the smoothness of the mica surface, the sense of brightness can be improved.

In the solar cell module 1 according to the present embodiment, the printed material 2 may include the transmissive smoke-printed layer 30 provided between the pattern printed layer 5 and the solar cell 302. Accordingly, the color development of the first color pattern layer 10 and the second color pattern layer 20 is superior, and design aesthetics can be further improved. Furthermore, because the transmissive smoke-printed layer 30 has transmissivity, a decrease in transmitted light to the solar cell 302 is favorably suppressed.

Although the solar cell module 1 according to the present disclosure has been described above, the solar cell module according to the present disclosure is not limited to the above-described embodiments, and various other modifications are possible. Hereinafter, modified examples of the printed material 2 used in the solar cell module 1 will be described.

In the third disclosure as well, the printed materials 2A, 2B, and 2C shown in FIGS. 4, 6, and 7 of the first disclosure may be adopted instead of the printed material 2.

In addition, the solar cell module according to the present disclosure is not limited to the above-described embodiments or various modification examples, and various other modifications are possible. For example, the second color pattern layer may include first interference pigments that generate first interference lights different from each other, and the first color pattern layer may include second interference pigments generating a single-colored second interference light different from the color mixture shown by the plurality of first interference pigments of the second color pattern layer.

In addition, in the above-described embodiments and the like, each of the first interference pigments and the second interference pigments included a plurality of first titanium dioxide-coated mica particles and a plurality of second titanium dioxide-coated mica particles, but at least one of the first interference pigments and the second interference pigments only needs to include a plurality of first titanium dioxide-coated mica particles and a plurality of second titanium dioxide-coated mica particles. Furthermore, in the above-described embodiments, the first color pigment chips were first interference pigments of two colors, but the first color pigment chips may be first interference pigments of three or more colors. In addition, the first interference pigments of multiple colors may be mixed.

### Reference Signs List

1 Solar cell module, 1, 2A, 2B, 2C Printed material, 4 Light transmissive base material, 5 Pattern printed layer, 10 First color pattern layer, 11 First color dot, 12 First color binder, 13 First color pigment chip, 14a, 14b First interference pigment, 15a, 15b First interference light, 18a, 16a, 25a First titanium dioxide-coated mica, 18b, 16b, 25b Second titanium dioxide-coated mica, 17a, 17b First interference light, 20 Second color pattern layer, 21 Second color dot, 22 Second color binder, 23 Second color pigment chip, 24 Second interference pigment, 25 Second interference light, 30 Transmissive smoke-printed layer, 40 White pattern layer, 41 Silver dot, 42 Silver binder, 43 Silver pigment chip, 101 Film layer, 102 Vapor deposition layer, 104A Top coat layer, 104B Glass layer, 202 Printed layer, SC, 302 Solar cell, 303 Back surface material, 304 Sealing material layer, 305 Surface plate, 307 Hard coat layer

## Claims

1. A solar cell module comprising:
a solar cell; and
a printed material disposed on a light-receiving surface side of the solar cell and including a light transmissive base material and a pattern printed layer,
wherein the pattern printed layer includes
a first color pattern layer provided on one surface of the light transmissive base material and composed of a plurality of first color dots; and
a second color pattern layer provided on the first color pattern layer and composed of a plurality of second color dots,
wherein each of the plurality of first color dots includes a first color binder and a plurality of first color pigment chips dispersed within the first color binder,
wherein each of the plurality of second color dots includes a second color binder and a plurality of second color pigment chips dispersed within the second color binder,
wherein any one of the plurality of first color pigment chips and the plurality of second color pigment chips is first interference pigments of multiple colors that each generate a different first interference light,
wherein the other of the plurality of first color pigment chips and the plurality of second color pigment chips is second interference pigments generating a single-colored second interference light different from a color mixture shown by the plurality of first interference pigments, and
wherein the plurality of first interference lights and the second interference light are additively mixed.

2. The solar cell module according to claim 1, further comprising:
a white pattern layer provided on the second color pattern layer and composed of a plurality of silver dots,
wherein each of the plurality of silver dots includes a silver binder and a plurality of silver pigment chips dispersed within the silver binder.

3. The solar cell module according to claim 1, further comprising a transmissive smoke-printed layer provided on an outermost surface opposite to the light transmissive base material with respect to the pattern printed layer.

4. The solar cell module according to claim 1, wherein the first interference pigments and the second interference pigments each include titanium dioxide-coated mica having a particle size of 25 µm to 60 µm.

5. The solar cell module according to claim 1,
wherein a content of the plurality of first color pigment chips is in a range of 0.5 parts by weight to 20 parts by weight relative to 100 parts by weight of the first color binder, and
wherein a content of the plurality of second color pigment chips is in a range of 0.5 parts by weight to 20 parts by weight relative to 100 parts by weight of the second color binder.

6. A solar cell module comprising:
a solar cell; and
a vapor deposition layer disposed on a light-receiving surface side of the solar cell and formed by metal vapor deposition.

7. The solar cell module according to claim 6, further comprising a decorated printed layer disposed on an outer layer side with respect to the light-receiving surface relative to the vapor deposition layer.

8. The solar cell module according to claim 7,
wherein the printed layer includes
a first color pattern layer composed of a plurality of first color dots; and
a second color pattern layer provided on the first color pattern layer and composed of a plurality of second color dots,
wherein each of the plurality of first color dots includes a first color binder and a plurality of first color pigment chips dispersed within the first color binder,
wherein each of the plurality of second color dots includes a second color binder and a plurality of second color pigment chips dispersed within the second color binder,
wherein any one of the plurality of first color pigment chips and the plurality of second color pigment chips is first interference pigments of multiple colors that each generate a different first interference light,
wherein the other of the plurality of first color pigment chips and the plurality of second color pigment chips is second interference pigments generating a single-colored second interference light different from a color mixture shown by the plurality of first interference pigments, and
wherein the plurality of first interference lights and the second interference light are additively mixed.

9. The solar cell module according to claim 6, further comprising a film layer as an outermost layer with respect to the light-receiving surface.

10. The solar cell module according to claim 6, further comprising a top coat layer as an outermost layer with respect to the light-receiving surface.

11. The solar cell module according to claim 6, further comprising a glass layer as an outermost layer with respect to the light-receiving surface.

12. The solar cell module according to claim 6, wherein a total light transmittance of the vapor deposition layer is 25% to 75%.

13. A solar cell module comprising:
at least one solar cell; and
a printed material disposed on a light-receiving surface side of the solar cell and having a pattern printed layer,
wherein the pattern printed layer includes
a first color pattern layer composed of a plurality of first color dots; and
a second color pattern layer provided so as to overlap with the first color pattern layer and composed of a plurality of second color dots,
wherein each of the plurality of first color dots includes a first color binder and a plurality of first color pigment chips dispersed within the first color binder,
wherein each of the plurality of second color dots includes a second color binder and a plurality of second color pigment chips dispersed within the second color binder,
wherein any one of the plurality of first color pigment chips and the plurality of second color pigment chips is first interference pigments of multiple colors that generate first interference lights different from each other,
wherein the other of the plurality of first color pigment chips and the plurality of second color pigment chips is second interference pigments generating a single-colored second interference light different from a color mixture shown by the first interference pigments of multiple colors,
wherein at least one of the first interference pigments and the second interference pigments includes a small particle size grade interference pigment including a particle size range of 5 µm to 25 µm and a large particle size grade interference pigment including a particle size range of 25 µm to 40 µm,
wherein the small particle size grade interference pigment is disposed to fill gaps between the large particle size grade interference pigments, and
wherein the plurality of first interference lights and the second interference light are additively mixed.

14. The solar cell module according to claim 13, wherein the large particle size grade interference pigment includes a particle size range of 25 µm to 60 µm.

15. The solar cell module according to claim 13 or 14, wherein at least one of the small particle size grade interference pigment and the large particle size grade interference pigment is an interference pigment including titanium dioxide-coated mica.

16. The solar cell module according to claim 13 or 14, wherein the printed material further has a light transmissive base material provided on the first color pattern layer.

17. The solar cell module according to claim 13 or 14,
wherein the printed material further has a white pattern layer composed of a plurality of silver dots,
wherein each of the plurality of silver dots includes a silver binder and a plurality of silver pigment chips dispersed within the silver binder, and
wherein the second color pattern layer is provided on the white pattern layer.

18. The solar cell module according to claim 13 or 14, wherein the printed material further has a transmissive smoke-printed layer provided between the pattern printed layer and the solar cell.

19. The solar cell module according to claim 13 or 14, wherein each thickness of the first color pattern layer and the second color pattern layer is 10 µm or less.

20. The solar cell module according to claim 13 or 14, wherein both the first interference pigments and the second interference pigments include a small particle size grade interference pigment including a particle size range of 5 µm to 25 µm and a large particle size grade interference pigment including a particle size range of 25 µm to 40 µm.
